Europäisches Patentamt

European Patent Office

Office européen des brevets

(11) Publication number: **0 180 776 B1**

# EUROPEAN PATENT SPECIFICATION

(45) Date of publication of patent specification: **29.01.92** (51) Int. Cl.⁵: **G01R 31/28**

(21) Application number: **85112588.0**

(22) Date of filing: **04.10.85**

(54) Chip-on-chip semiconductor device.

(30) Priority: **05.10.84 JP 209236/84**

(43) Date of publication of application:
**14.05.86 Bulletin 86/20**

(45) Publication of the grant of the patent:
**29.01.92 Bulletin 92/05**

(84) Designated Contracting States:
**DE FR GB**

(56) References cited:

**IBM TECHNICAL DISCLOSURE BULLETIN, vol. 21 no. 1, June 1978, pages 159-163, New York, US; P. GOEL: "Level sensitive scan design test generation in presence of certain design rule violations"**

**PATENT ABSTRACTS OF JAPAN, vol. 7, no. 272 (E-214)[1417], 3rd December 1983; & JP-A-58 154 254**

**PATENT ABSTRACTS OF JAPAN, vol. 7, no. 62 (E-164)[1207], 15th March 1983; & JP-A-57 208 154**

(73) Proprietor: **FUJITSU LIMITED**
**1015, Kamikodanaka Nakahara-ku**
**Kawasaki-shi Kanagawa 211(JP)**

(72) Inventor: **Fujii, Shigeru c/o Fujitsu Limited**
**Patent Department 1015 Kamikodanaka**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

Rank Xerox (UK) Business Services

# Description

The present invention relates to a semiconductor device based on so-called chip-on-chip technology.

In accordance with the trend towards increasing versatility and packing density in large scale integration (LSI) semiconductor devices, there is an increasing demand for the incorporation of various circuits, different in their functions, in an LSI package. However, it is difficult to integrate circuits, which are usually fabricated according to different technologies, on a common semiconductor substrate. Such difficulty generally arises in the provision of combinations of MOS (metal oxide semiconductor) or CMOS (complementary MOS type and bipolar type circuits, such combinations including the combination of a CMOS (complementary MOS) circuit and a TTL (transistor-transistor logic) circuit, of a CMOS digital circuit and an analog integrated circuit such as an A/D (analog-to-digital) or a D/A (digital-to-analog) converter, and of a CMOS circuit and an ECL (emitter coupled logic) circuit. In principle, such combinations might be possible in semiconductor chips: however, the benefits provided by the combinations could not compensate for the probable complexities of processes required to achieve them.

Further, the expected yield of products with such combinations would be extremely low.

Chip-on-chip technology has been proposed as a means for achieving such combinations whilst retaining advantages of existing MOS and bipolar technologies. That is, it has been proposed to combine individual semiconductor chips, having circuits based on respective different technologies such as those mentioned above, in a stacked structure and to provide wirings for interconnecting the chips via respective corresponding terminals formed thereon. Generally, it is proposed that in such a stacked structure the upper chip is smaller than the lower chip. With the introduction of a chip-on-chip structure, each chip involved can be fabricated with the respective optimized processes as employed for conventional MOS, CMOS or bipolar semiconductor devices.

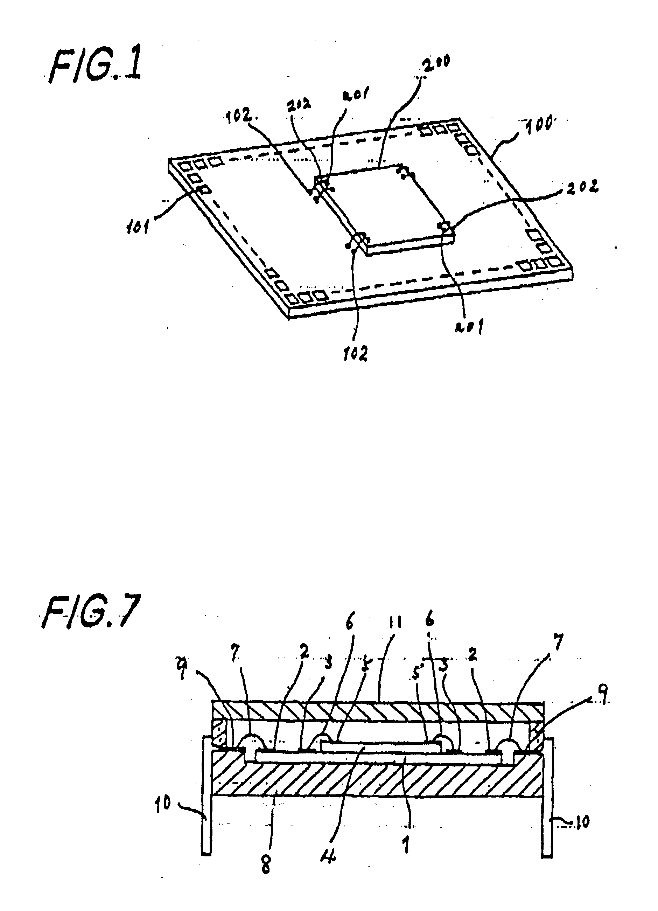

Fig. 1 is a schematic perspective view illustrating the conceptual structure of a chip-on-chip semiconductor device. Referring to Fig. 1, a small semiconductor chip 200 (second chip) having an internal circuit (second internal circuit; not shown) is mounted on a larger semiconductor chip 100 (first chip) having another internal circuit (first internal circuit; not shown). A number of terminals 101 are formed at a peripheral region of the first chip 100. These terminals 101, each having a relatively large size, 100 μm square for example, are used for connections to external circuits and/or power sources. At an inner region of the first chip 100 there are formed a number of smaller terminals 102, each having a size of 10 μm square, for example. The terminals 102 are used for interconnections between the chips 100 and 200. For instance, data signals output from the chip 100 to the chip 200 or input to the chip 100 from the chip 200 are transmitted through the terminals 102. Further, control signals or power voltages are supplied to the second internal circuit via the terminals 102. Therefore, each of the terminals 102 is wired to a corresponding terminal 201 on the second chip via a corresponding wiring line 202. Each wiring line 202 may be a thin film wiring line of aluminium, for example, formed by thin film and lithographic technologies.

Each of the chips 100 and 200 is subjected to individual functional tests (an individual test) in a separate condition (separate from the other chip) before the chips are stacked into a chip-on-chip structure. Therefore, it is required that each of the chips 100 and 200 be provided with a circuit configuration allowing individual testing of the chip. This involves two requirements:

(1) Since outputs of each of the first and second internal circuits are open circuited during an individual test, any means used to take out output signals from an internal circuit must be provided in respect of each of the chips 100 and 200 to be tested by an external test circuit;

(2) In an internal circuit formed on a chip based on a MOS technology, MOS transistors or CMOS inverters are generally used as input means. The gates of these MOS transistors or CMOS inverters must tentatively (temporarily) be clamped at respective appropriate potentials so as not to be left floating during an individual test. This is because such floating gate MOS transistors or CMOS inverters are in unidentified logical states and would disturb the operation of the internal circuit, thereby making the test invalid. Moreover, if a number of floating gate CMOS inverters are used as input means of an internal circuit, a power source or the relevant power supplying line could be damaged by extraordinary excess currents flowing through the floating gate CMOS inverters, because the power source or power supplying line will have been designed to comply with maximum current flowing during transitions of the CMOS inverters in normal operation conditions. The above-mentioned requirements are applicable to both the first and second internal circuits, if the circuits on both the first and second chips are fabricated based on MOS technology.

It is easy to think of providing the terminals 102 and 201 each with sufficient area to accommodate the touch of a probe which is tentatively (temporarily) used for connections between the relevant internal circuit to be tested and an external test circuit or power supply. However, such a terminal area is inevitably large, for example 100 μm square, as mentioned above, and reduces the chip area available to be allotted to device regions. Therefore, it is undesirable to form a number of such large terminals on a chip, from the point of view of chip area utilization. In particular, it is undesirable to form such large terminals at the inner region of the chip 100, which region should be used for forming therein as many as possible functional elements such as transistors.

Thus, there exists a difficult problem relating to the trade off between requirements necessary for allowing individual tests prior to stacking of chips into a chip-on-chip structure and reduction in chip area utilization efficiency.

Patent Abstracts of Japan, Vol. 7, No. 272 [E-214] [1417] December 1983, referring to JP-A-58 154254, discloses a semiconductor device with a first chip and a second chip mounted on the first chip. The first chip comprises nodes and terminals, which terminals are formed at an inner region of the first chip for exchanging signals with the second chip. The nodes are for connecting the first chip to external leads.

IBM Technical Disclosure Bulletin, Vol. 21, No. 1, June 1978, pages 159 to 163, discloses (c.f. Fig. 1 thereof) a selection circuit with two AND-gates (AND), an OR-gate (OR), latches (B, latches L1, L2), and a control input terminal (X) for receiving control signals for the selecting circuit. Similar circuits are disclosed also for other control signals (Y and Z).

According to the present invention there is provided a semiconductor device, including a first chip and a second chip mounted on the first chip, the first chip comprising nodes and terminals, which terminals are formed at an inner region of the first chip and are for exchanging signals with the second chip;

the first and second chips respectively having first and second internal circuits formed thereon,

said nodes comprising an input node and an output node for said first internal circuit,

said terminals of the first chip comprising an input terminal for receiving incoming signals from said second internal circuit, and an output terminal connected to said output node of the first internal circuit;

characterised in that

the first chip further comprises:-

a selecting circuit having first and second input nodes and an output node, said first and second input nodes of said selecting circuit being connected to said output terminal and said input terminal, respectively, said output node of said selecting circuit being connected to said input node of said first internal circuit, and

a control signal input terminal connected to said selecting circuit and for receiving control signals for said selecting circuit, said selecting circuit being operable for switching so as to connect said input node of said first internal circuit to said input terminal or to said output terminal in accordance with the control signals.

An embodiment of the present invention can provide a semiconductor device based on a chip-on-chip technology, wherein each of the chips constituting the device can be subjected to a test individually in a respective separated condition without unduly reducing (whilst maintaining satisfactory) chip area utilization efficiency.

An embodiment of the present invention can provide a semiconductor device based on a chip-on-chip technology, wherein the chip area utilization efficiency in the chips constituting the device can substantially be increased and wherein each of the chips can be subjected to a test individually in a respective separated condition.

In accordance with an embodiment of the present invention a semiconductor device has a first chip and a second chip mounted on the first chip, the two chips having respective internal circuits, wherein the first chip comprises a selecting circuit and a control signal input terminal for receiving control signals for the selecting circuit. The selecting circuit switches to connect an input of the internal circuit of the first chip to an output of the internal circuit of the first chip or to an output of the internal circuit of the second chip according to the control signals supplied for the control signal input terminal.

In accordance with another embodiment of the present invention a semiconductor device has a first chip and a second chip mounted on the first chip, the two chips having respective internal circuits, wherein the first chip comprises a selecting circuit, a control signal input terminal for receiving control signals for the selecting circuit, and an impedance means connected between the control signal input terminal and a voltage source, and the second chip comprises a biasing means to be connected to the control signal input terminal of the first chip so as to clamp the control signal input terminal at a predetermined voltage when interconnections between the first and second chips are completed.

The present invention relates in particular to circuit configuration on a chip of a chip-on-chip device.

Reference is made, by way of example, to the accompanying drawings, in which:

Fig. 1 is a schematic perspective view illustrating the conceptual structure of a chip-on-chip semiconductor device;

Fig. 2 is a schematic circuit block diagram illustrating the circuitry of a chip-on-chip type semiconductor device in accordance with a first embodiment of the present invention;

Fig. 3 is a schematic circuit block diagram illustrating the circuitry of a chip-on-chip type semiconductor device in accordance with a second embodiment of the present invention;

Fig. 4 is a schematic circuit block diagram illustrating the circuitry of a chip-on-chip type semiconductor device in accordance with a third embodiment of the present invention;

Fig. 5 is a partial circuit diagram for explaining an extended application of a selecting circuit as shown in Fig. 4;

Fig. 6 is a circuit diagram of a transfer gate which can be used as a selecting circuit in embodiments of the present invention; and

Fig. 7 is a schematic cross-sectional view of a chip-on-chip type semiconductor device package containing chips fabricated according to the present invention.

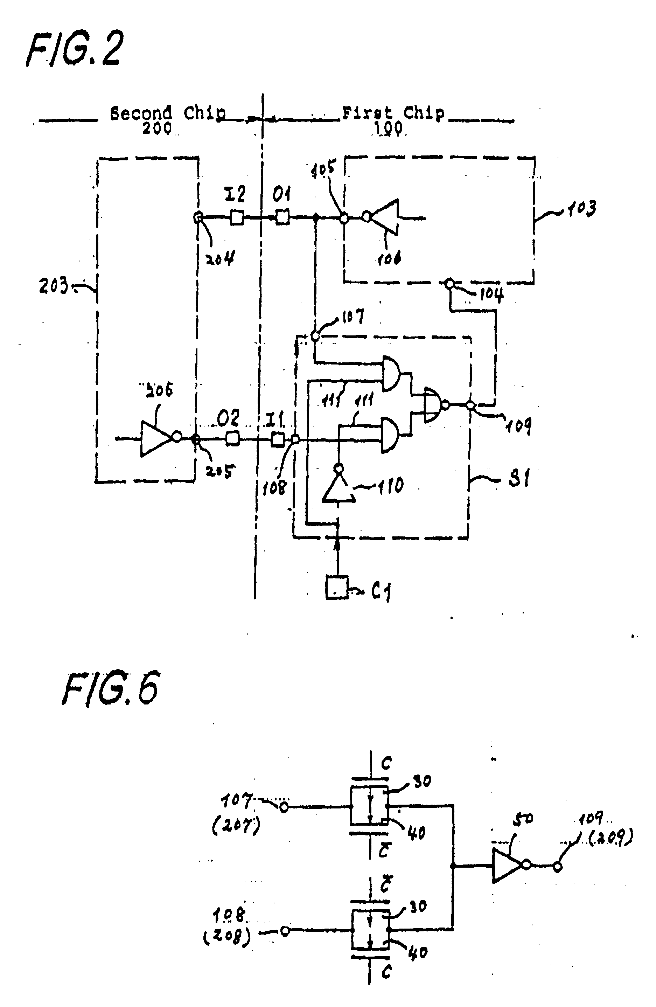

The schematic circuit block diagram of Fig. 2 illustrates a first embodiment of the present invention.

In Fig. 2, like reference signs designate like or corresponding parts to those of Fig. 1.

The semiconductor device of Fig. 2 includes a first chip 100 and a second chip 200. The first chip comprises a first internal circuit 103 having an input node 104 and an output node 105 connected to an output buffer 106, an output terminal O1, an input terminal I1, a selecting circuit S1 having two input nodes 107 and 108 and an output node 109, and a control signal input terminal C1 for receiving external control signals for the selecting circuit S1. The second chip 200 comprises a second internal circuit 203 having an input node 204 and an output node 205 connected to an output driver 206, an input terminal I2 and an output terminal O2.

The output nodes 105 and 205 are connected to the respective output terminals O1 and O2, input node 204 is connected to the input terminal I2 and input node 108 is connected to input terminal I1. The output terminal O1 and input terminal I2 are respectively formed at an inner region on the first chip 100 and at a peripheral region of the second chip 200 and are connected to each other. Similarly, the input terminal I1 and output terminal O2 are respectively formed at an inner region of the first chip 100 and a peripheral region of the second chip 200 and are connected to each other.

The input nodes 107 and 108 of the selecting circuit S1 are respectively connected to the output terminal O1 and the input terminal I1 (as mentioned above) and the output node 109 of the selecting circuit S1 is connected to the input node 104 of the first internal circuit 103. The selecting circuit S1 may comprise a well-known AND-OR-inverter gate provided with an inverter 110 connected (at each of its opposite ends) to one of control signal input lines 111, as shown in Fig. 2. The control signal input terminal C1 is formed as one of the terminals 101 at a peripheral region of the first chip 100 as shown in Fig. 1.

In the circuit configuration as shown in Fig. 2, when a high level signal is supplied to the control signal input terminal C1, the selecting circuit S1 switches to connect the input node 104 to the output node 105, and a closed loop is established between the output node 105 and the input node 104 of the internal circuit 103. If a signal relative to (corresponding to) the incoming signal to the input node 104 is output from the first internal circuit 103 to a terminal 101 formed at a peripheral region of the first chip 100 (see Fig. 1), the operation of the internal circuit 103 in a test mode can be confirmed by an external test circuit (not shown) connected to the terminal 101. Thus, the chip 100 can be subjected to the aforesaid individual test in a separate condition or even in the completed chip-on-chip structure.

On the other hand, when a low level signal is supplied to the control signal input terminal C1, the selecting circuit S1 switches to connect the input node 104 to the input terminal I1. In this case, output signals from the second internal circuit 203 are transmitted to the input node 104 of the first internal circuit 103, and the chips 100 and 200 can be tested in the completed chip-on-chip structure configuration.

The first internal circuit 103 and second internal circuit 203 have respective pluralities of like output nodes 105 and 205 and input nodes 104 and 204, therefore the first chip 100 and second chip 200 are provided with respective corresponding pluralities of like output terminals O1 and O2 and input terminals I1 and I2. These output nodes and input nodes of each internal circuit are not always equal in number, therefore the output and input terminals of each of the chips 100 and 200 are not always formed in one-to-one correspondence. Further, all of the output or input nodes are not always responsible for (involved in or responsive in the course of) the individual test.

When MOS transistors or CMOS inverters are used for constituting input means, their gates connected to the above-mentioned irresponsible (non-responsive or uninvolved) input nodes must be clamped at respective appropriate potential levels so as not to be left floating during an individual test (individual chip test) for reasons as mentioned before. In the circuit configuration of Fig. 2, even if the input node 104 is such an irresponsible input formed from a MOS transistor or CMOS inverter, the gate of the MOS transistor or CMOS inverter is clamped at the level of the output 109 of the selecting circuit S1 during the individual test, the level being determined by the output signals on the output node 105. Thus, the aforementioned problems relating to a floating gate MOS transistor or CMOS inverter can be eliminated.

As will be clearly understood from the above explanation of the first embodiment, each of the terminals such as output terminal O1 and input terminal I1, and other input terminals connected to aforesaid floating gate MOS transistors or CMOS inverters, is freed from the need to accommodate the touch of an external probe and can be formed as small as 10 μm square, for example, at the inner region of the first chip 100.

As for the second chip 200, each of the input terminal I2 and output terminal O2, which terminals are used for connections to an external test circuit, are formed as large as 100 μm square, for example, so as to accommodate the touch of an external probe. However, other input terminals, connected to aforesaid floating gate MOS transistors or CMOS inverters, can be clamped at respective appropriate potential levels by incorporating a selecting circuit as in the first chip 100, and can be formed as small as 10 μm square, for example. Thus, chip area utilization efficiency can be increased as compared with a chip configuration wherein each of the output and input terminals such as O1 and I1 is formed as large as is necessary to accommodate a touch of an external probe. It will be clear to those skilled in the art that the chip area necessary to form such a selecting circuit as mentioned above is small as compared with that of a large terminal, 100 μm square for example.

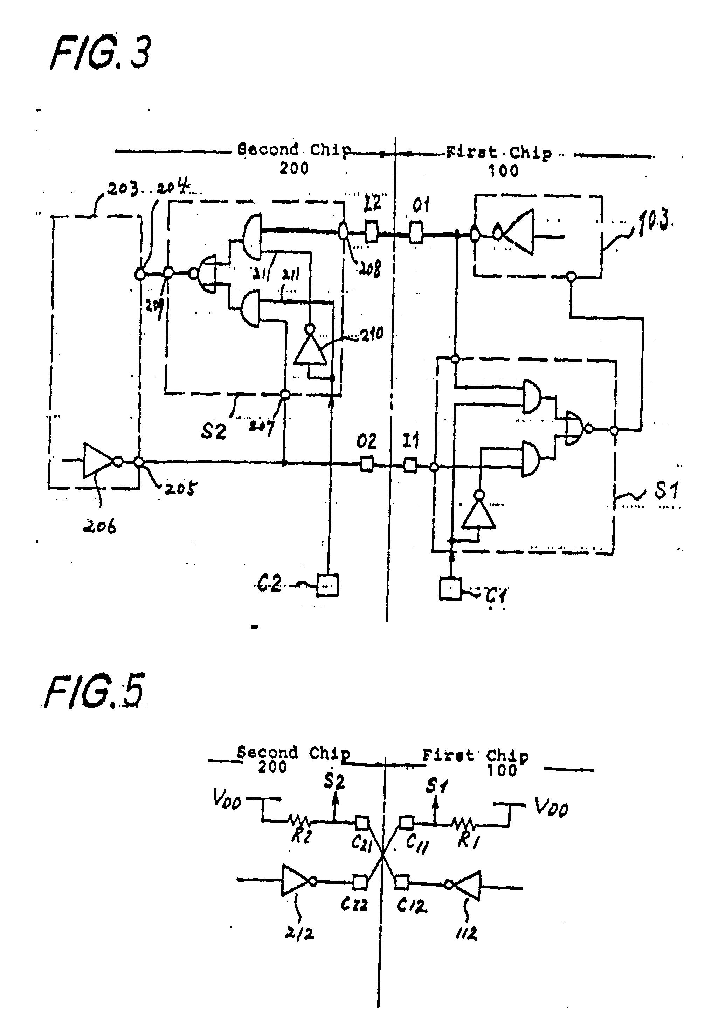

The schematic circuit block diagram of Fig. 3 illustrates a second embodiment of the present invention, wherein the second chip 200 comprises a second selecting circuit S2 for the purpose of clamping a floating gate of an input MOS transistor or CMOS inverter (on the second chip) as mentioned above. In Fig. 3, like reference signs designate like or corresponding parts to those shown in previous Figures.

Comparing Fig. 3 with Fig. 2, the second chip 200 in the second embodiment further includes the second selecting circuit S2 having two input nodes 207 and 208, which are respectively connected to the output terminal O2 and the input terminal I2, and an output node 209 connected to the input node 204 of the second internal circuit 203. The selecting circuit S2 may also comprise a well-known AND-OR-inverter gate provided with an inverter 210 connected (at each of its opposite ends) to one of control signal input lines 211 as shown in Fig. 3. The second chip 200 is provided with a control signal input terminal C2 for supplying external control signals to the selecting circuit S2.

The operation of the second selecting circuit S2 is exactly the same as the selecting circuit S1 of the first chip 100 in the embodiment whose operation has been explained with reference to Fig. 2. Simply speaking, the selecting circuit S2 switches to connect the input node 204 of the second internal circuit 203 to the output node 205 or to the input terminal I2 according to the changes in level of the control signals supplied to the control signal input terminal C2. Thus, floating gates of MOS transistors or CMOS inverters of the second internal circuit 203, which are connected to the input nodes irresponsible for the individual test, can be clamped at respective appropriate potential levels, and the aforesaid problems relating to floating gate MOS transistors or CMOS inverters can be eliminated.

In the second chip 200, since the input and output terminals I2 and O2 are formed at the peripheral region of the chip 200 together with the control signal input terminal C2, each of the terminals can be large enough to accommodate the touch of an external probe for an individual test. Therefore, the provision of the selecting circuit S2 has validity only for the solution of problems relating to floating gate MOS transistors or CMOS inverters in this second embodiment. However, chip area utilization efficiency can further be increased.

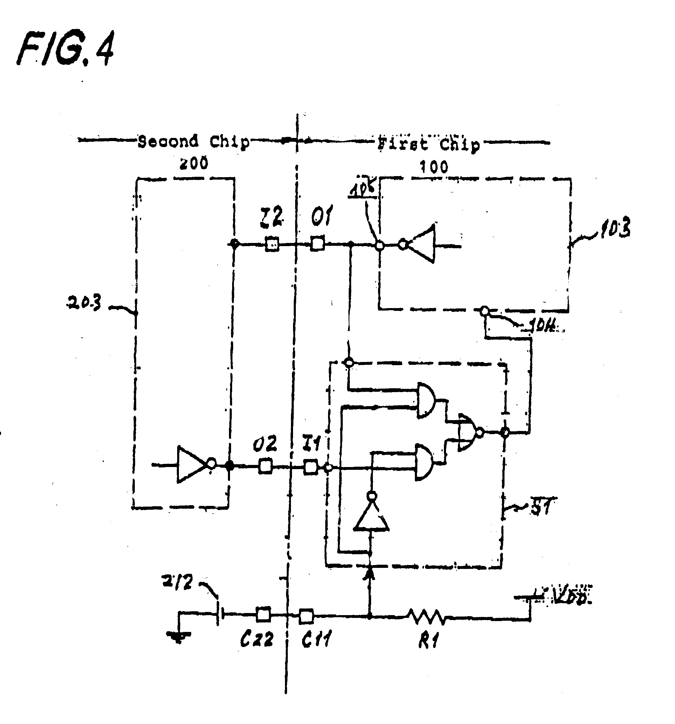

The schematic circuit block diagram of Fig. 4 illustrates a third embodiment of the present invention. In Fig. 4, like reference signs designate like or corresponding parts to those shown in previous Figures. In this embodiment, the chip-on-chip type semiconductor device including the first chip 100 and the second chip 200 is provided with an impedance means R1 and a biasing means 212. The impedance means R1, having impedance of few megohms, for example, is connected between a control signal input terminal C11 formed at an inner region of the first chip 100 and a voltage source $V_{DD}$, a positive voltage supply line, for example. The biasing means 212 has an output impedance lower than the impedance means R1 and is connected to a control signal output terminal C22. The control signal output terminal C22 is formed at a peripheral region of the second chip 200 and interconnected with the control signal input terminal C11 so as to supply a negative voltage to the control signal input terminal C11. The biasing means 212 may be a negative voltage supply line or a ground line.

In the circuit configuration of Fig. 4, the control signal input terminal C11 is clamped at high a level by the voltage source $V_{DD}$ before the chips 100 and 200 are interconnected with each other. On the other hand, when the control signal input terminal C11 and control signal output terminal C22 are connected to each other in a completed chip-on-chip structure, the control signal input terminal C11 is pulled down to a low level by the biasing means 212. Accordingly, the selecting circuit S1 switches to connect the input node 104 of the first internal circuit 103 to the output node 105 during an individual test and to the input terminal I1 of the first chip 100 during the test of the completed chip-on-chip configuration.

Thus, the switching of the selecting circuit S1 is spontaneously performed according to whether or not the terminals C11 and C22 are interconnected to each other. Therefore, it is unnecessary to supply external control signals to the selecting circuit S1 via a large terminal 101 formed at the peripheral region of the chip 100. As a result, the terminals C11 and C22 may be as small as 10 $\mu$m square, for example. This means that the chip area utilization efficiency can be increased further.

Fig. 5 is a partial circuit diagram for explaining an extended application of spontaneous switching as provided by the selecting circuit in Fig. 4. In Fig. 5, like reference signs designate like or corresponding parts to those shown in previous Figures. The first chip 100 and second chip 200 in Fig. 5 further include a biasing means 112 connected to another control signal output terminal C12, and an impedance means R2 connected between a further control signal input terminal C21 and a voltage source $V_{DD}$, respectively. The control signal output terminal C12 is connected to the control signal input terminal C21 in a completed chip-on-chip structure. The voltage source $V_{DD}$ may be a positive voltage supplying line, for example. Thus, the control signal input terminal C21 is clamped at a high level by the voltage source $V_{DD}$ before the chips 100 and 200 are interconnected and pulled down to a low level by the biasing means 112 when the chips 100 and 200 are interconnected in a completed chip-on-chip structure. Therefore, if the circuit of Fig. 5 is implemented in a chip-on-chip semiconductor device as shown in Fig. 3, the operation of each of the selecting circuits S1 and S2 can be spontaneously performed, as explained with reference to Fig. 4, and the large control signal input terminal C2 in Fig. 3 can be replaced by the small terminals C21 and C22, and hence chip area utilization efficiency further increased.

The impedance means R1 can be formed from a diffusion layer or polysilicon layer. However, they also may be composed of FETs (field effect transistors). Fig. 5 shows an example of the use of a driver circuit for each of the biasing means 112 and 212. If the biasing means 112 and 212 are formed from FETs as well as the impedance means R1 and R2, the gate-width (W) to gate-length (L) ratios (W/L) of respective FETs for the impedance means and the biasing means are estimated as follows.

If each of the FETs for the impedance means R1 and R2 is designed to have a W/L ratio of 5/50, it is considered appropriate for each of the FETs for the biasing means 112 and 212 to have a W/L ratio larger than 50/5, thus, the FETs for the biasing means 112 and 212 are provided with a $\beta$ value (a voltage-independent factor relating to transmission conductance $g_m$ and relative to the w/L ratio) 100 times larger than that of the impedance FETs, and with a sufficient driving capability for the pull-down operation.

Fig. 6 is a circuit diagram illustrating an alternative configuration for a selecting circuit which alternative configuration can be applied in all the embodiments of the present invention described above. In Fig. 6, like reference signs designate like or corresponding parts to those shown in previous Figures. The selecting circuit of Fig. 6 comprises two pairs, each comprising a p-channel transistor 30 and an n-channel transistor 40 connected in parallel to each other to form a transfer gate, and an inverter 50. The p- and n-channel transistor pairs have respective common sources or drains connected to input nodes 107 (or 207) and 108 (or 208), respectively, and respective common drains or sources which are commonly connected to the input of the inverter 50 having an output connected to an output node 109 (or 209).

The selecting circuit of Fig. 6 switches to select input signals on the input 107 (207) or 108 (208) according to the change between an incoming high level control signal C and an incoming low level control signal $\overline{C}$. Thus, signals on the selected input node 107 (207) or 108 (208) are transmitted to the output node 109 (or 209). The high and low level control signals are externally supplied via the control signal input terminal C1 or C2 in Figs. 2 or 3, or the high level control signal C and the low level control signal $\overline{C}$ are respectively supplied by the voltage source $V_{DD}$ and the biasing means 112 or 212 in Fig. 4 or 5.

Alternatively, the selecting circuit may comprise two transfer gates and an inverter, the transfer gates having a common output connected to the inverter, and one of the transfer gates having another inverter connected to an input thereof.

It will be clear for those skilled in the art that selecting circuits, impedance means and biasing means in the above embodiments can be fabricated with the same technology as is used for other circuits formed on the relevant chip.

Fig. 7 is a schematic cross-sectional view of a chip-on-chip semiconductor device package having first and second chips and fabricated according to the present invention. Referring to Fig. 7, the first chip 1 is disposed on a substrate 8 and the second chip 4 is mounted on the first chip in a face-up condition. The first and second chips are wired with each other by wirings 6 through respective terminals 3 and 5 formed on the chips 1 and 4. Terminals 2 formed at the peripheral region of the first chip 1 are each connected to an internal lead 9 of a metallised layer formed in the package with corresponding wiring 7. Each of the internal leads 9 is connected to a corresponding one of external leads 10 formed outside of the package. 11 is a lid of the package. Each of the wirings 6 between the chips 1 and 4 can be replaced by a bump of a conductor or a beam reed (lead).

**Claims**

1. A semiconductor device, including a first chip (100) and a second chip (200) mounted on the first chip, the first chip (100) comprising nodes (104, 105) and terminals (I1, O1), which terminals are formed at an inner region of the first chip (100) and are for exchanging signals with the second chip (200);

the first (100) and second (200) chips respectively having first (103) and second (203) internal circuits formed thereon, said nodes (104, 105) comprising an input node (104) and an output node (105) for said first internal circuit (103), said terminals (I1, O1) of the first chip (100) comprising an input terminal (I1), for receiving incoming signals from said second internal circuit (203), and an output terminal (O1) connected to said output node (105) of the first internal circuit (103);
characterised in that
the first chip (100) further comprises:-
a selecting circuit (S1) having first (107) and second (108) input nodes and an output node (109), said first (107) and second (108) input nodes of said selecting circuit (S1) being connected to said output terminal (O1) and said input terminal (I1), respectively, said output node (109) of said selecting circuit being connected to said input node (104) of said first internal circuit (103), and
a control signal input terminal (C1; C11) connected to said selecting circuit (S1) and for receiving control signals for said selecting circuit (S1), said selecting circuit being operable for switching so as to connect said input node (104) of said first internal circuit (103) to said input terminal (I1) or to said output terminal (O1) in accordance with the control signals.

2. A device as claimed in claim 1, wherein the control signal input terminal (C1) is formed at a peripheral region of said first chip (100).

3. A device as claimed in claim 1, wherein said control signal input terminal (C11) is formed at said inner region of said first chip (100);
wherein said first chip (100) further comprises:-
impedance means (R1) connected between said control signal input terminal (C11) and a voltage source (V$_{DD}$), said impedance means (R1) having a limited impedance;
wherein said second chip (200) comprises:-
a control signal output terminal (C22) to be connected to said control signal input terminal (C11) of said first chip (100), and
biasing means (212) connected to said control signal output terminal (C22) and clamping said control signal input terminal (C11) of said first chip (100) at a predetermined voltage after the completion of wiring between said control signal output terminal (C22) of said second chip (200) and said control signal input terminal (C11) of said first chip (100);
and wherein said selecting circuit (S1) switches said input node (104) of said first internal circuit (103) to said output terminal (O1) of said first chip (100) in accordance with a voltage supplied through said impedance means (R1) before the completion of wiring between said control signal input terminal (C11) of said first chip (100) and said control signal output terminal (C22) of said second chip (200), and said selecting circuit (S1) switches said input node (104) of said first internal circuit (103) to said input (I1) terminal of said first chip (100) in accordance with said predetermined voltage supplied from said biasing means (R1) after the completion of wiring between said control signal input terminal (C11) of said first chip (100) and said control signal output terminal (C22) of said second chip (200).

4. A semiconductor device as claimed in claim 3, wherein said control signal output terminal (C22) is formed at a peripheral region of said second chip (200).

5. A semiconductor device as claimed in claim 3 or 4, wherein said biasing means (212) is a driver circuit having an output connected to said control signal output terminal (C22) of said second chip (200) and an input connected to a voltage supplying line, said driver circuit having an output impedance lower than the impedance of said impedance means (R1).

6. A semi conductor device as claimed in any one of claims 3 to 5, wherein said impedance means (212) is a metal-insulator-semiconductor transistor having a source and drain connected between said control signal input terminal (C11) of said first chip and a voltage source (V$_{DD}$), said metal-insulator-semiconductor transistor having a gate clamped at a predetermined voltage.

7. A semiconductor device as claimed in any one of claims 3 to 6, wherein said voltage source (V$_{DD}$) is a power supplying line.

8. A semiconductor device as claimed in any preceding claim, wherein said selecting circuit (S1) comprises an AND-OR-inverter gate having two control signal inputs and an inverter (110) connected to one of said control signal inputs.

9. A semiconductor device as claimed in any one of claims 1 to 8, wherein said selecting circuit comprises two transfer gates and an inverter, said transfer gates having a common output connected to said inverter, one of said transfer gates having another inverter connected to an input thereof.

**Revendications**

1. Dispositif à semiconducteur, incluant une première puce (100) et une seconde puce (200) montée sur la première puce, la première puce (100) comprenant des noeuds (104, 105) et des bornes (I1, O1), ces bornes étant formées au niveau d'une région interne de la première puce (100) et étant destinées à l'échange de signaux avec la seconde puce (200) ;

les première (100) et seconde (200) puces ayant respectivement des premier (103) et second (203) circuits internes formés dessus ;

lesdits noeuds (104, 105) comprenant un noeud (104) d'entrée et un noeud de sortie (105) pour ledit premier circuit interne (103) ;

lesdites bornes (I1, O1) de la première puce (100) comprenant une borne d'entrée (I1) pour recevoir des signaux qui arrivent depuis ledit second circuit interne (203) et une borne de sortie (O1) connectée audit noeud de sortie (105) du premier circuit interne (103) ;

caractérisé en ce que la première puce (100) comprend en outre :

un circuit de sélection (S1) ayant des premier (107) et second (108) noeuds d'entrée et un noeud de sortie (109), lesdits premier (107) et second (108) noeuds d'entrée dudit circuit de sélection (S1) étant connectés respectivement à ladite borne de sortie (O1) et à ladite borne d'entrée (I1), ledit noeud de sortie (109) dudit circuit de sélection étant connecté audit noeud d'entrée (104) dudit premier circuit interne (103) ; et

une borne d'entrée de signal de commande (C1 ; C11) connectée audit circuit de sélection (S1) et destinée à recevoir des signaux de commande pour ledit circuit de sélection (S1), ledit circuit de sélection pouvant fonctionner en commutation de manière à connecter ledit noeud d'entrée (104) dudit premier circuit interne (103) à ladite borne d'entrée (I1) ou à ladite borne de sortie (O1) en fonction des signaux de commande.

2. Dispositif selon la revendication 1, dans lequel la borne d'entrée de signal de commande (C1) est formée au niveau d'une région périphérique de ladite première puce (100).

3. Dispositif selon la revendication 1, dans lequel ladite borne d'entrée de signal de commande (C11) est formée au niveau de ladite région interne de ladite première puce (100) ;

dans lequel ladite première puce (100) comprend en outre :

un moyen d'impédance (R1) connecté entre ladite borne d'entrée de signal de commande (C11) et une source de tension (V$_{DD}$), ledit moyen d'impédance (R1) ayant une impédance limitée ;

dans lequel ladite seconde puce (200) comprend :

une borne de sortie de signal de commande (C22) destinée à être connectée à ladite borne d'entrée de signal de commande (C11) de ladite première puce (100) ; et

un moyen de polarisation (212) connecté à ladite borne de sortie de signal de commande (C22) et verrouillant ladite borne d'entrée de signal de commande (C11) de ladite première puce (100) à une tension prédéterminée après l'établissement d'un câblage entre ladite borne de sortie de signal de commande (C22) de ladite seconde puce (200) et ladite borne d'entrée de signal de commande (C11) de ladite première puce (100) ;

et dans lequel ledit circuit de sélection (S1) commute ledit noeud d'entrée (104) dudit premier circuit interne (103) à ladite borne de sortie (O1) de ladite première puce (100) en fonction d'une tension acheminée au travers dudit moyen d'impédance (R1) avant l'établissement du câblage entre ladite borne d'entrée de signal de commande (C11) de ladite première puce (100) et ladite borne de sortie de signal de commande (C22) de ladite seconde puce (200), et ledit circuit de sélection (S1) commute ledit noeud d'entrée (104) dudit premier circuit interne (103) à ladite borne d'entrée (I1) de ladite première puce (100) en fonction de ladite tension prédéterminée acheminée depuis ledit moyen de polarisation (R1) après l'établissement du câblage entre ladite borne d'entrée de signal de commande (C11) de ladite première puce (100) et ladite borne de sortie de signal de commande (C22) de ladite seconde puce (200).

4. Dispositif à semiconducteur selon la revendication 3, dans lequel ladite borne de sortie de signal de commande (C22) est formée au niveau d'une région périphérique de ladite seconde puce (200).

5. Dispositif à semiconducteur selon la revendication 3 ou 4, dans lequel ledit moyen de polarisation (212) est un circuit de commande qui a une sortie connectée à ladite borne de sortie de signal de commande (C22) de ladite seconde puce (200) et une entrée connectée à une ligne d'alimentation en tension, ledit circuit de commande ayant une impédance de sortie inférieure à l'impédance dudit moyen d'impédance (R1).

6. Dispositif à semiconducteur selon l'une quelconque des revendications 3 à 5, dans lequel ledit moyen d'impédance (212) est un transistor métal-isolant-semiconducteur ayant une source et un drain connectés entre ladite borne d'entrée de signal de commande (C11) de ladite première puce et une source de tension ($V_{DD}$), ledit transistor métal-isolant-semiconducteur ayant une grille verrouillée à une tension prédéterminée.

7. Dispositif à semiconducteur selon l'une quelconque des revendications 3 à 6, dans lequel ladite source de tension ($V_{DD}$) est une ligne d'alimentation.

8. Dispositif à semiconducteur selon l'une quelconque des revendications précédentes, dans lequel ledit circuit de sélection (S1) comprend une porte ET-OU-inverseur ayant deux entrées de signal de commande et un inverseur (110) connecté à une desdites entrées de signal de commande.

9. Dispositif à semiconducteur selon l'une quelconque des revendications 1 à 8, dans lequel ledit circuit de sélection comprend deux portes de transfert et un inverseur, lesdites portes de transfert ayant une sortie commune connectée audit inverseur, une desdites portes de tansfert ayant un autre inverseur connecté à une de ses entrées.

## Patentansprüche

1. Halbleitervorrichtung, mit einem ersten Chip (100) und einem zweiten Chip (200), das auf dem ersten Chip montiert ist, welches erste Chip (100) Knoten (104, 105) und Anschlüsse (I1,O1) umfasst, die in einem inneren Bereich des ersten Chip (100) gebildet sind und zum Austauschen von Signalen mit dem zweiten Chip (200) dienen;

bei der das erste (100) und zweite (200) Chip, jeweils erste (103) und zweite (203) interne Schaltungen haben, die darauf gebildet sind, die genannten Knoten (104, 105) einen Eingangsknoten (104) und Ausgangsknoten (105) für die genannte erste interne Schaltung (103) umfassen;

die genannten Anschlüsse (I1, O1) des ersten Chip (100) einen Eingangsanschluß (I1) umfassen, um ankommende Signale von der genannten zweiten internen Schaltung (203) zu empfangen, und einen Ausgangsanschluß (O1), der mit dem genannten Ausgangsknoten (105) der ersten internen Schaltung (103) verbunden ist;

dadurch gekennzeichnet ist, daß

das erste Chip (100) ferner umfasst:-

eine Auswahlschaltung (S1), die erste (107) und zweite (108) Eingangsknoten und einen Ausgangsknoten (109) hat, welche ersten (107) und zweiten (108) Eingangsknoten der genannten Auswahlschaltung (S1) mit dem genannten Ausgangsanschluß (O1) bzw. dem genannten Eingangsanschluß (I1) verbunden sind, und der genannte Ausgangsknoten (109) und der genannten Auswahlschaltung mit dem genannten Eingangsknoten (104) der genannten ersten internen Schaltung (103) verbunden ist, und

einen Steuersignaleingangsanschluß (C1; C11), der mit der genannten Auswahlschaltung (S1) verbunden ist und zum Empfang von Steuersignalen für die genannte Auswahlschaltung (S1) dient, wobei die genannte Auswahlschaltung betreibbar ist, um so zu schalten, daß der genannte Eingangsnknoten (104) der genannten ersten internen Schaltung (103) mit dem genannten Eingangsanschluß (I1) oder dem genannten Ausgangsanschluß (O1) in Übereinstimmung mit den Steuersignalen verbunden wird.

2. Vorrichtung nach Anspruch 1, bei der der Steuersignaleingangsanschluß (C1) in einem peripheren Bereich des genannten ersten Chip (100) gebildet ist.

3. Vorrichtung nach Anspruch 1, bei der der genannte Steuersignaleingangsanschluß (C11) bei dem genannten inneren Bereich des genannten ersten Chip (100) gebildet ist;

wobei das genannte erste Chip (100) ferner umfasst:-

eine Impedanzeinrichtung (R1), die zwischen dem genannten Steuersignaleingangsanschluß (C11) und einer Spannungsquelle (V$_{DD}$) verbunden ist, welche Impedanzeinrichtungen (R1) eine begrenzte Impedanz hat;

bei der das genannte Chip (200) umfasst:-

einen Steuersignalausgangsanschluß (C22) der mit dem genannten Steuersignaleingangsanschluß (C11) des genannten ersten Chip (100) zu verbinden ist, und

eine Vorspanneinrichtung (212), die mit dem genannten Steuersignalausgangsanschluß (C22) verbunden ist und den genannten Steuersignaleingangsanschluß (C11) des genannten ersten Chip (100) auf eine vorbestimmte Spannung klammert, nach Vervollständigung der Verdrahtung zwischen dem Steuersignalausgangsanschluß (C22) des genannten zweiten Chip (200) und dem genannten Steuersignaleingangsanschluß (C11) des genannten ersten Chip (100);

bei der die genannte Auswahlschaltung (S1) den genannten Eingangsknoten (104) der genannten ersten internen Schaltung (103) auf den genannten Ausgangsanschluß (O1) des genannten ersten Chip (100) schaltet, in Übereinstimmung mit einer Spannung, die über die genannte Impedanzeinrichtung (R1) zugeführt wird, vor Vervollständigung der Verdrahtung zwischen dem genannten Steuersignaleingangsanschluß (C11) des genannten ersten Chip (100) und dem genannten Steuersignalausgangsanschluß (C22) des genannten zweiten Chip (200), und die genannte Auswahlschaltung (S1) den genannten Eingangsknoten (104) der genannten ersten internen Schaltung (103) auf den genannten Eingangsanschluß (I1) des genannten ersten Chip (100) schaltet, in Übereinstimmung mit der genannten vorbestimmten Spannung, die von der genannten Vorspanneinrichtung (R1) geliefert wird, nach der Vervollständigung der Verdrahtung zwischen dem genannten Steuersignalanschluß (C11) des genannten ersten Chip (100) und dem genannten Steuersignalausgangsanschlusses (C22) des genannten zweiten Chip (200).

4. Halbleitervorrichtung nach Anspruch 3, bei der der genannten Steuersignalausgangsanschluß (C22) in einem peripheren Bereich des genannten zweiten Chip (200) gebildet ist.

5. Halbleitervorrichtung nach Anspruch 3 oder 4, bei der die genannte Vorspanneinrichtung (212) eine Treiberschaltung ist, die einen Ausgang hat, der mit dem genannten Steuersignalausgangsanschluß (C22) und des genannten zweiten Chip (200) verbunden ist, und einen Eingang, der mit einer Spannungsversorgungsleitung verbunden ist, welche Treiberschaltung eine Ausgangsimpedanz hat, die niedriger als die Impedanz der genannten Impedanzeinrichtung (R1) ist.

6. Halbleitervorrichtung nach einem der Ansprüche 3 bis 5, bei der die genannte Impedanzeinrichtung (212) ein Metall-Isolator-Halbleiter-Transistor ist, der eine Source und ein Drain hat, die zwischen dem genannten Steuersignaleingangsanschluß (C11) des genannten ersten Chip und einer Spannungsquelle (V$_{DD}$) verbunden sind, welcher Metall-Isolator-Halbleiter-Transistor eine Gate hat, das auf eine vorbestimmte Spannung geklammert ist.

7. Halbleitervorrichtung nach einem der Ansprüche 3 bis 6, bei die genannte Spannungquelle (V$_{DD}$) eine Spannungsversorgungsleitung ist.

8. Halbleitervorrichtung nach einem der vorhergehenden Ansprüche, bei der die genannte Auswahlschaltung (S1) ein UND-OR-Invertergate umfasst, das zwei Steuersignaleingänge und einen Inverter (110) hat, der mit einem der genannten Steuersignaleingänge verbunden ist.

9. Halbleitervorrichtung nach einem der Ansprüche 1 bis 8, bei der die genannte Auswahlschaltung zwei Transfergates und einen Inverter umfasst, welche Transfergates einen gemeinsamen Ausgang haben, der mit dem genannten Inverter verbunden ist, wobei eines der Transfergates einen anderen Inverter hat, der mit seinem einen Eingang verbunden ist.

FIG.1

FIG.7

# FIG.2

# FIG.6

# FIG.3

# FIG.5

# FIG.4